# EUROPEAN PATENT APPLICATION

(11) **EP 4 749 687 A1**
(43) Date of publication of application: **27.05.2026**
(21) Application number: 24853867.0
(22) Date of filing: 15.08.2024
(51) Int. Cl.: H01L 23/538

(54) **SEMICONDUCTOR STRUCTURE AND MANUFACTURING METHOD THEREFOR, AND ELECTRONIC DEVICE**

(30) Priority: 17.08.2023 CN 202311044401
(71) Applicant: HUAWEI TECHNOLOGIES CO., LTD., Shenzhen 518129 (CN)
(72) Inventor: LI, Heng, Shenzhen, Guangdong 518129 (CN); DONG, Jinwen, Shenzhen, Guangdong 518129 (CN); ZHU, Jifeng, Shenzhen, Guangdong 518129 (CN)
(74) Representative: Pfenning, Meinig & Partner mbB
(86) International application number: PCT/CN2024/112448
(87) International publication number: WO 2025/036461

(57) **Abstract**

Embodiments of this application disclose a semiconductor structure, a manufacturing method therefor, and an electronic device. The semiconductor structure may be a wafer, a bare die obtained by cutting the wafer, a chip obtained by packaging the bare die, or the like, to resolve problems of insufficient filling of a conductive material in a substrate, silicon wafer cracking caused by easy expansion, and the like. The semiconductor structure includes a substrate, a dielectric layer, a protective layer, and a conductive pillar. The dielectric layer is stacked on the substrate. There is a via that passes through the dielectric layer and the substrate in a direction from the dielectric layer to the substrate. The via includes a first portion formed within the substrate. The protective layer covers a part of an inner wall that is of the first portion and that is close to the dielectric layer. The conductive pillar is disposed in the via, and is electrically connected to an electronic component on the dielectric layer. Existence of the protective layer avoids generation of an under cut near a side that is of the first portion and that is close to the dielectric layer, thereby resolving the problems of insufficient filling of the conductive material in the substrate, silicon wafer cracking caused by easy expansion, and the like.

## Description

This application claims priority to Chinese Patent Application No. 202311044401.2, filed with the China National Intellectual Property Administration on August 17, 2023 and entitled "SEMICONDUCTOR STRUCTURE, MANUFACTURING METHOD THEREFOR, AND ELECTRONIC DEVICE", which is incorporated herein by reference in its entirety.

### TECHNICAL FIELD

This application relates to the field of semiconductor technologies, and in particular, to a semiconductor structure, a manufacturing method for the semiconductor structure, and an electronic device.

### BACKGROUND

In an example chip manufacturing scenario, a silicon wafer is used as a substrate. In a chip manufacturing process, a through silicon via (through silicon via, TSV) is etched in the silicon wafer, an insulation layer (liner), an adhesive layer (barrier), a seed (seed), and the like are deposited on an inner wall of the through silicon via, and finally the through silicon via is filled with a conductive material to form a conductive pillar, so as to implement electrical interconnection between electronic components in a chip and electrical interconnection between the electronic components and an external circuit.

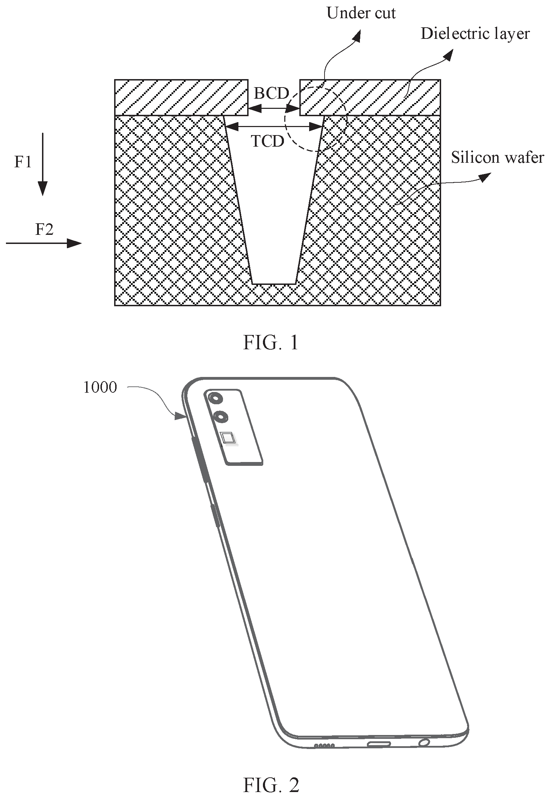

FIG. 1 is a diagram of etching of a through silicon via. As shown in FIG. 1, when a depth-to-width ratio of the through silicon via (a ratio of a depth of the through silicon via in a first direction F1 to a width of the through silicon via in a second direction F2) is large, over-etching of the silicon wafer is likely to occur in the second direction F2, consequently generating an under cut (under cut) near a junction between the silicon wafer and a dielectric layer. Specifically, if the through silicon via is divided into a first portion located in the substrate and a second portion located in the dielectric layer, over-etching occurs in the second direction F2 as follows: In the second direction F2, a bottom critical dimension (bottom CD, BCD) of the second portion is less than a top critical dimension (top CD, TCD) of the first portion.

Existence of the under cut causes discontinuous deposition of the insulation layer, the adhesive layer, and the seed, and insufficient filling of the conductive material. In addition, in an annealing process after filling of the conductive material, the conductive pillar is prone to expansion, leading to silicon wafer cracking.

### SUMMARY

Embodiments of this application provide a semiconductor structure, a manufacturing method for the semiconductor structure, and an electronic device. The semiconductor structure may be a wafer, a bare die obtained by cutting the wafer, a chip obtained by packaging the bare die, or the like, to resolve the following problems caused due to generation of an under cut shown in FIG. 1 when a via is etched on a substrate: discontinuous deposition of an insulation layer, an adhesive layer, and a seed on an inner wall of the via, insufficient filling of a conductive material, silicon wafer cracking caused by easy expansion of a conductive pillar, and the like.

To achieve the foregoing objectives, the following technical solutions are used in embodiments of this application.

According to a first aspect, a semiconductor structure is provided, including a substrate, a dielectric layer, a protective layer, and a conductive pillar. The dielectric layer is stacked on the substrate. There is a via that passes through the dielectric layer and the substrate in a first direction (the first direction herein is a direction from the dielectric layer to the substrate). The via includes a first portion formed within the substrate. The protective layer covers a part of an inner wall that is of the first portion and that is close to the dielectric layer. The conductive pillar is disposed in the via, and is electrically connected to an electronic component on the dielectric layer.

Existence of the protective layer avoids generation of an under cut near a side that is of the first portion and that is close to the dielectric layer. This is because, in a process of etching the via in the substrate, before the under cut is generated, the protective layer is formed on an upper inner wall of the first portion (in this case, an inner wall of a groove that has been etched in the substrate forms an upper inner wall of a first portion in a subsequently manufactured finished chip), to protect the upper inner wall of the first portion through the protective layer. Then, the substrate continues to be etched to deepen a depth of the groove. If the process is briefly described as "etching the substrate and depositing the protective layer before the under cut is generated", a depth of the via required by the process can be achieved by repeating the process a plurality of times. In addition, the protective layer protects the upper inner wall of the first portion. In this way, during etching of the via in the substrate, no over-etching is caused to the substrate in a width direction of the via as an etching depth increases. Therefore, generation of the under cut may be avoided near the side that is of the first portion and that is close to the dielectric layer.

With reference to the first aspect, in a possible implementation, the first portion includes a first segment close to the dielectric layer and a second segment that is away from the dielectric layer and that is continuous with the first segment, and a minimum radial size of the first segment is greater than a maximum radial size of the second segment. The protective layer covers an inner wall of the first segment, and a side surface that is of the protective layer and that is close to the conductive pillar is flush with a surface of an inner wall of the second segment, to form a continuous surface with the surface of the inner wall of the second segment.

With reference to the first aspect, in a possible implementation, the second segment has a contact surface that faces the dielectric layer at a junction with the first segment. A side that is of the protective layer and that is close to the second segment is connected to the contact surface. A thickness of the protective layer at a joint between the protective layer and the contact surface is equal to a size of the contact surface in a second direction. The second direction is a direction perpendicular to the first direction. This means that the side surface that is of the protective layer and that is close to the conductive pillar is flush with the surface of the inner wall of the second segment, that is, the side surface that is of the protective layer and that is close to the conductive pillar and the surface of the inner wall of the second segment form a continuous surface. Correspondingly, a radial size of the conductive pillar decreases continuously.

With reference to the first aspect, in a possible implementation, the dielectric layer further includes an active region, and the active region includes the electronic component. In this way, the semiconductor structure forms a chip.

With reference to the first aspect, in a possible implementation, the semiconductor structure further includes an active layer. The active layer is disposed on the dielectric layer and/or a side that is of the substrate and that is away from the dielectric layer. The electronic component connected to the conductive pillar is an electronic component in the active layer.

With reference to the first aspect, in a possible implementation, the semiconductor structure further includes a chip. The chip is disposed on the dielectric layer and/or the side that is of the substrate and that is away from the dielectric layer. The electronic component connected to the conductive pillar is an electronic component in the chip. In this way, the semiconductor structure forms a chip package structure.

With reference to the first aspect, in a possible implementation, the via further includes a second portion formed within the dielectric layer, and a surface of an inner wall of the second portion is flush with the side surface that is of the protective layer and that is close to the conductive pillar, to form a continuous surface with the side surface that is of the protective layer and that is close to the conductive pillar. Alternatively, the inner wall of the second portion is covered by a second dielectric layer, and a side surface that is of the second dielectric layer and that is close to the conductive pillar is flush with the side surface that is of the protective layer and that is close to the conductive pillar, to form a continuous surface with the side surface that is of the protective layer and that is close to the conductive pillar. This means that the side surface that is of the second dielectric layer and that is close to the conductive pillar, the side surface that is of the protective layer and that is close to the conductive pillar, and the inner wall of the second segment form a continuous surface. In other words, there is no under cut near a junction between the first portion and the second portion. The protective layer and the second dielectric layer may be made of a same material, or may be made of different materials. The protective layer may be connected to the second dielectric layer. In other words, at a joint between the protective layer and the second dielectric layer, there is no observable interface, or there may be an observable interface.

It can be learned from the foregoing that, there is no under cut near the junction between the first portion and the second portion, and the protective layer is located between the conductive pillar and an inner wall of the via. In other words, before filling of a conductive material used to form the conductive pillar, the side surface that is of the protective layer and that is close to the conductive pillar and the surface of the inner wall of the second segment have formed the continuous surface. Therefore, it can be ensured that the conductive material is fully filled, thereby ensuring quality of the conductive pillar and performance of the chip.

With reference to the first aspect, in a possible implementation, a depth-to-width ratio of the via is greater than or equal to 10. When the depth-to-width ratio of the via is large, over-etching of the substrate is likely to occur in the second direction, and an under cut is generated near a junction between the substrate and the dielectric layer. Therefore, for the chip in embodiments of this application, the depth-to-width ratio of the via in the substrate is greater than or equal to 10. The chip structure solution in embodiments of this application is more applicable to an application scenario in which a chip size is large and a depth-to-width ratio of a via in a substrate is large.

With reference to the first aspect, in a possible implementation, a radial size of the via at a first position is greater than a radial size of the via at a second position, and the first position is closer to the dielectric layer than the second position. The radial size of the via at the first position is greater than or equal to the radial size of the via at the second position. This means that a TCD of the first portion is less than or equal to a BCD of the second portion, indicating that there is no under cut at the junction between the first portion and the second portion.

With reference to the first aspect, in a possible implementation, a radial size of the first portion decreases in a gradient manner in the first direction.

With reference to the first aspect, in a possible implementation, in the first direction, a thickness of the protective layer at a third position is greater than a thickness of the protective layer at a fourth position, and the third position is closer to the dielectric layer than the fourth position. This is because, in a process of etching the via in the substrate, according to a depth requirement of the via, the foregoing process of "etching the substrate and depositing the protective layer before the under cut is generated" may be repeated a plurality of times. In other words, the protective layer is deposited, a plurality of times, on the side wall of the groove that has been etched, so that the thickness of the protective layer increases at a position closer to the dielectric layer, and the thickness of the protective layer decreases at a position farther away from the dielectric layer.

With reference to the first aspect, in a possible implementation, the semiconductor structure further includes an insulation layer, and the insulation layer covers a continuous surface formed by the protective layer and the surface of the inner wall of the second segment.

With reference to the first aspect, in a possible implementation, the semiconductor structure further includes an adhesive layer, and the adhesive layer covers an insulation layer and is located between the conductive pillar and the insulation layer. In this way, the adhesive layer is located between the insulation layer and the conductive pillar, and plays a role of bonding and fastening the conductive pillar.

With reference to the first aspect, in a possible implementation, the protective layer includes SiCN, SiON, OX, SiN, SiOCN, SiC, or SiOC.

With reference to the first aspect, in a possible implementation, the insulation layer includes silicon oxide or another organic matter.

According to a second aspect, an embodiment of this application further provides a manufacturing method for a semiconductor structure, including:
forming a dielectric layer on a substrate, where the dielectric layer includes a conductive pattern, and the conductive pattern indicates a position at which a conductive pillar is formed in the substrate; and
preparing the conductive pillar in the substrate based on the position, indicated by the conductive pattern, at which the conductive pillar is formed in the substrate, and electrically connecting the conductive pillar to an electronic component on the dielectric layer.

The conductive pillar is formed in a via that passes through the dielectric layer and the substrate in a first direction. The via includes a first portion formed within the substrate. A part of an inner wall that is of the first portion and that is close to the dielectric layer is covered by a protective layer. The first direction is a direction from the dielectric layer to the substrate.

With reference to the second aspect, in a possible implementation, the via further includes a second portion formed within the dielectric layer, and the conductive pattern includes the second portion; and preparing the conductive pillar in the substrate based on the position, indicated by the conductive pattern, at which the conductive pillar is formed in the substrate includes:
etching, in a region that is of the substrate and that is exposed to the second portion, the substrate in the first direction to form a first groove in the substrate, where the first groove forms a first segment of the first portion;
forming, on a side wall of the first groove, the protective layer used to protect the side wall;
continuing to etch the substrate in the first direction on a bottom wall of the first groove, to form a second groove in the substrate, where the second groove forms a second segment of the first portion; and
forming the conductive pillar in a space formed by the first segment and the second segment.

With reference to the second aspect, in a possible implementation, forming, on the side wall of the first groove, the protective layer used to protect the side wall includes: forming an initial dielectric layer on an inner wall of the first groove; and removing a part that is of the initial dielectric layer and that is located on the bottom wall of the first groove.

With reference to the second aspect, in a possible implementation, a surface of the side wall of the first groove is flush with a surface of an inner wall of the second portion.

With reference to the second aspect, in a possible implementation, at a junction between the first groove and the second portion, a size of the first groove in a second direction is equal to a size of the second portion in the second direction, and the second direction is perpendicular to the first direction.

With reference to the second aspect, in a possible implementation, a side surface that is of the protective layer and that is close to the conductive pillar is flush with a surface of an inner wall of the second groove.

With reference to the second aspect, in a possible implementation, a minimum radial size of the first groove in a second direction is greater than a maximum radial size of the second groove in the second direction, and the second direction is perpendicular to the first direction.

With reference to the second aspect, in a possible implementation, forming the conductive pillar in the space formed by the first segment and the second segment includes: forming an insulation layer on the protective layer and a surface of an inner wall of the second groove; forming an adhesive layer on the insulation layer; and forming the conductive pillar in the space obtained after the insulation layer and the adhesive layer are formed.

With reference to the second aspect, in a possible implementation, forming the initial dielectric layer on the inner wall of the first groove includes: forming the initial dielectric layer on an inner wall of the second portion and the inner wall of the first groove.

According to a third aspect, an embodiment of this application provides an electronic device, including a mainboard and any one of the foregoing semiconductor structures electrically connected to the mainboard.

For technical effects brought by any design manner in the second aspect and the third aspect, refer to technical effects brought by different design manners in the first aspect. Details are not described herein again.

### BRIEF DESCRIPTION OF DRAWINGS

FIG. 1 is a diagram of etching a through silicon via;
FIG. 2 is a three-dimensional diagram of an electronic device according to an embodiment of this application;
FIG. 3 is an exploded view of an electronic device according to an embodiment of this application;
FIG. 4 is a diagram of a structure of a chip package structure and a mainboard in an electronic device according to an embodiment of this application;
FIG. 5 is a diagram of a chip package structure in an electronic device according to an embodiment of this application;
FIG. 6 is a diagram of a chip according to an embodiment of this application;
FIG. 7 is a diagram of another chip according to an embodiment of this application;
FIG. 8 is an exploded diagram of a chip according to an embodiment of this application;
FIG. 9 is a diagram of still another chip according to an embodiment of this application;
FIG. 10 is a process diagram of a manufacturing process of a semiconductor structure according to an embodiment of this application;
FIG. 11 is a diagram of a chip package structure according to an embodiment of this application;
FIG. 12 is a diagram of another chip package structure according to an embodiment of this application;
FIG. 13 is a flowchart of a manufacturing method for a semiconductor structure according to an embodiment of this application;
FIG. 14 is a flowchart of another manufacturing method for a semiconductor structure according to an embodiment of this application; and
FIG. 15 is a process diagram of another manufacturing process of a semiconductor structure according to an embodiment of this application.

### DESCRIPTION OF EMBODIMENTS

The following describes the technical solutions in embodiments of this application with reference to the accompanying drawings in embodiments of this application.

In the descriptions of this application, unless otherwise specified, "/" indicates that associated objects are in an "or" relationship. For example, A/B may represent A or B. In this application, "and/or" describes only an association relationship between associated objects and represents that three relationships may exist. For example, A and/or B may indicate: Only A exists, both A and B exist, and only B exists, where A and B may be singular or plural.

In addition, in the descriptions of this application, "a plurality of" means two or more than two unless otherwise specified. "At least one of the following items (pieces)" or a similar expression thereof means any combination of these items, including a single item (piece) or any combination of a plurality of items (pieces). For example, at least one item (piece) of a, b, or c may indicate: a, b, c, a and b, a and c, b and c, or a, b, and c, where a, b, and c may be singular or plural.

In addition, to clearly describe the technical solutions in embodiments of this application, terms such as "first" and "second" are used in embodiments of this application to distinguish between same items or similar items that provide basically same functions or purposes. A person skilled in the art may understand that the terms such as "first" and "second" do not limit a quantity or an execution sequence, and the terms such as "first" and "second" do not indicate a definite difference. In addition, in embodiments of this application, a word like "example" or "for example" is used to represent giving an example, an illustration, or a description. Any embodiment or design scheme described as an "example" or "for example" in embodiments of this application should not be explained as being more preferred or having more advantages than another embodiment or design scheme. Exactly, use of the terms such as "example" or "for example" is intended to present a related concept in a specific manner for ease of understanding.

In addition, service scenarios described in embodiments of this application are intended to describe the technical solutions in embodiments of this application more clearly, and do not constitute a limitation on the technical solutions provided in embodiments of this application. A person of ordinary skill in the art can know that the technical solutions provided in embodiments of this application are also applicable to similar technical problems with emergence of new service scenarios.

To resolve a problem that an under cut is generated in a process of etching a through silicon via as pointed out in the Background, in a related technology, for example, in a bosch process, a macro-etching process is decomposed into a plurality of cycles of micro-etching processes, and each cycle includes two steps: "etching a silicon wafer" and "depositing a protective layer on a side wall of a groove that has been etched". When duration of macro-etching remains unchanged, a larger quantity of cycles indicates a shorter etching time of each cycle. In this way, the etching time of each cycle is shortened, and protective effect of the protective layer (for example, carbon tetrafluoride) is leveraged to protect the side wall of the etched groove. This can avoid over-etching in the width direction of the through silicon via, thereby preventing generation of the under cut.

However, due to limitation of a machine capability, the foregoing solution is applicable only to the etching process in which the through silicon via has a small depth-to-width ratio, that is, optimization is limited. When the depth-to-width ratio is large, generation of the under cut cannot be completely avoided.

In view of this, embodiments of this application provide a semiconductor structure and an electronic device including the semiconductor structure.

In some application scenarios, the semiconductor structure mentioned in this specification may be a wafer, a bare die obtained by cutting the wafer, a chip obtained by packaging the bare die, or the like. In the semiconductor structure, there is no under cut shown in FIG. 1 in a through silicon via of a substrate. Therefore, an insulation layer, an adhesive layer, and a seed layer deposited on an inner wall of the through silicon via are flat and continuous, so that a conductive material fully fills the through silicon via, and functions of the semiconductor structure and the electronic device are ensured.

The electronic device includes but is not limited to an electronic device in information technology (IT) and communication technology (CT) fields, for example, a device that needs to perform data processing/storage/receiving and sending, such as a server, an optical communication device, a mobile phone, a tablet computer (tablet personal computer), a laptop computer (laptop computer), a personal digital assistant (personal digital assistant, PDA), a camera, a personal computer, a notebook computer, an in-vehicle device, a wearable device, augmented reality (augmented reality, AR) glasses, an AR helmet, virtual reality (virtual reality, VR) glasses, or a VR helmet. A specific form of the electronic device is not specially limited in embodiments of this application. For ease of description, the following is all described by using an example in which the electronic device is a mobile phone shown in FIG. 2.

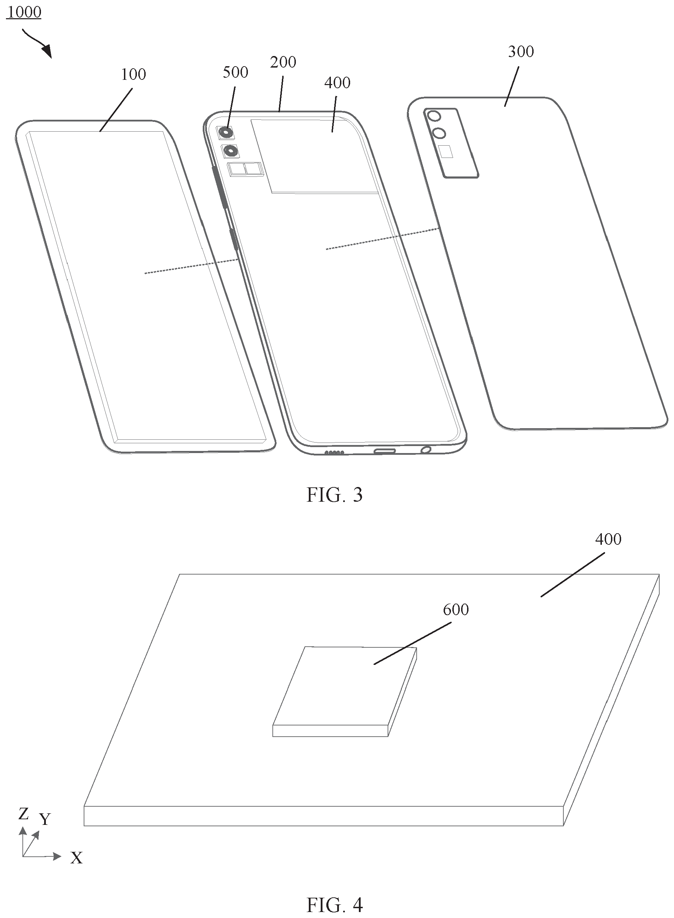

FIG. 2 is a three-dimensional diagram of an electronic device according to some embodiments of this application. FIG. 3 is an exploded view of the electronic device shown in FIG. 2. Refer to FIG. 2 and FIG. 3. An electronic device 1000 is a mobile phone. The electronic device 1000 may include a screen 100, a middle frame 200, a rear housing 300, and a mainboard 400 fastened to the middle frame 200, as shown in FIG. 2.

It may be understood that FIG. 2 and FIG. 3 merely show some components included in the electronic device 1000 as examples. Actual shapes, actual sizes, actual positions, and actual structures of these components are not limited by FIG. 2 and FIG. 3. For example, in some other examples, the electronic device 1000 may alternatively not include the screen 100. Alternatively, the electronic device 1000 may further include a camera 500 shown in FIG. 2.

In this embodiment of this application, the electronic device 1000 further includes a chip package structure 600 shown in FIG. 4. The chip package structure mentioned in this embodiment of this application may also be referred to as an integrated circuit. As shown in FIG. 4, the chip package structure 600 is disposed on the mainboard 400 and is electrically connected to the mainboard 400. For example, the chip package structure 600 may be electrically connected to the mainboard 400 by using a ball grid array (ball grid array, BGA) or a plurality of copper pillar bumps (copper pillar bump, CPB) arranged in an array, so that the chip package structure 600 can implement signal transmission with other devices or a device stacking structure on the mainboard 400.

It should be noted that the mainboard 400 may be a printed circuit board (printed circuit board, PCB). There may be one, two, or more chip package structures 600 on the mainboard 400. This is not limited in this application.

For ease of the following descriptions, some accompanying drawings in embodiments of this application show a three-dimensional space coordinate system, namely, an X, Y, and Z coordinate system. Refer to FIG. 4. A plane on which the mainboard 400 is located is an XY plane. For example, the mainboard 400 shown in FIG. 4 is rectangular. An X axis may be a length direction of the mainboard 400, a Y axis may be a width direction of the mainboard 400, and a Z axis is a direction perpendicular to or approximately perpendicular to the mainboard 400 within a manufacturing tolerance range. It may be understood that a width dimension of the mainboard 400 is less than a length dimension of the mainboard 400.

In different application scenarios, the semiconductor structure provided in embodiments of this application may be the chip package structure shown in FIG. 4, or may be a chip in the chip package structure shown in FIG. 4. The following first describes a specific implementation in which the semiconductor structure is a chip, and then describes a specific implementation in which the semiconductor structure is a chip package structure.

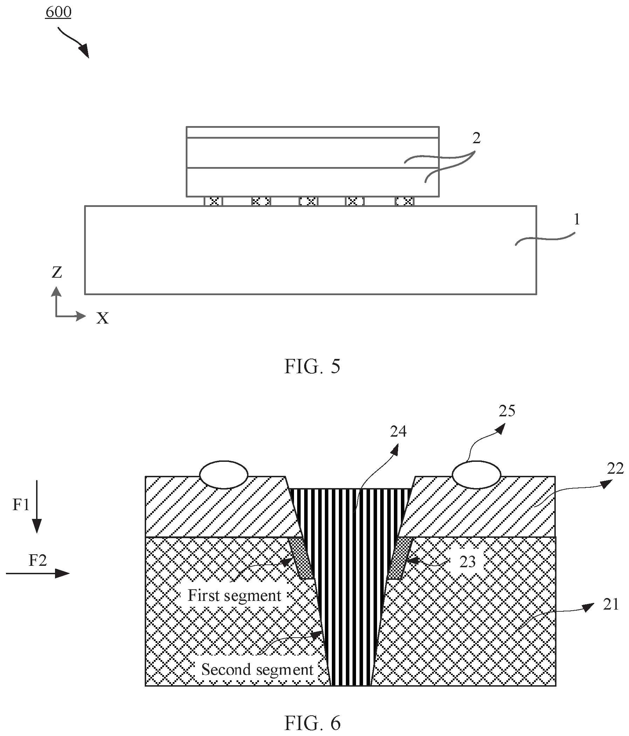

Refer to FIG. 5. A chip package structure 600 includes a base board 1 and a chip 2 disposed on the base board 1. The base board 1 is located between the mainboard 400 and the chip 2. The base board 1 includes a wiring layer, and the chip 2 is electrically connected to the wiring layer. The chip 2 may be a bare die (namely, a single die), or may be a chip stacking structure (that is, a plurality of bare dies are laminated). A quantity of chips 2 in the chip package structure 600 is not limited in this application. There may be one or more chips in the chip package structure 600.

The semiconductor structure provided in embodiments of this application may be the foregoing chip 2. The chip 2 may be specifically a processing chip having a data processing function, for example, a chip that can process data, such as a central processing unit (central processing unit, CPU), a system on chip (system on chip, SOC), or a graphics processing unit (graphics processing unit, GPU). The foregoing memory may be a random access memory (random access memory, RAM), or may be a read-only memory (read-only memory, ROM).

Refer to FIG. 6. The chip 2 includes a substrate 21, a dielectric layer 22, a protective layer 23, a conductive pillar 24, and an electronic component 25. The dielectric layer 22 is stacked on the substrate 21. There is a via that passes through the dielectric layer 22 and the substrate 21 in a first direction F1 (the first direction herein is a direction from the dielectric layer 22 to the substrate 21). In the following content, for ease of describing a structure of the chip 2, the via is divided into a first portion formed within the substrate and a second portion formed within the dielectric layer, and a part of an inner wall that is of the first portion and that is close to the dielectric layer is referred to as an upper inner wall. The protective layer 23 covers the upper inner wall of the first portion. The conductive pillar 24 is disposed in the via, and is electrically connected to the electronic component 25.

In the chip 2 shown in FIG. 6, existence of the protective layer 23 avoids that a TCD of the first portion is greater than a BCD of the second portion, that is, generation of an under cut is avoided near a junction between the first portion and the second portion. This is because, in a process of etching the via in the substrate 21, before the under cut is generated, the protective layer 23 is formed on the upper inner wall of the first portion (in this case, an inner wall of a groove that has been etched in the substrate 21 forms an upper inner wall of a first portion in a subsequently manufactured finished chip), to protect the upper inner wall of the first portion through the protective layer 23. Then, the substrate 21 continues to be etched to deepen a depth of the groove. In the following content, the process is briefly described as a plurality of cycles of "etching the substrate and depositing the protective layer before the under cut is generated" until a depth of the via meets a process requirement. The protective layer 23 protects the upper inner wall of the first portion. In this way, during etching of the via in the substrate 21, no over-etching is caused to the substrate 21 in a width direction of the via as an etching depth increases. Therefore, the TCD of the first portion is not greater than the BCD of the second portion, that is, generation of the under cut is avoided near the junction between the first portion and the second portion.

In a possible implementation, the dielectric layer may further include an active region, and the electronic component 25 is an active device in the active region, as shown in FIG. 6.

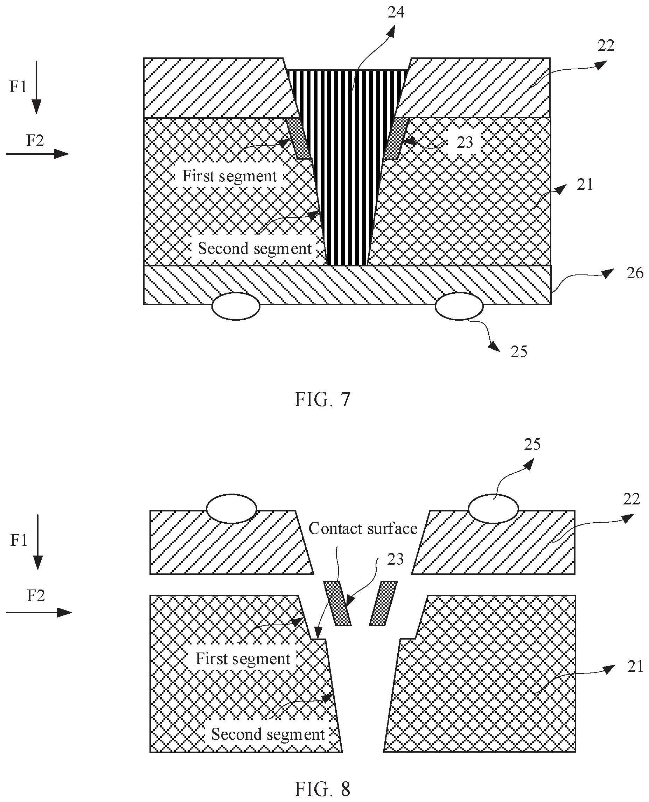

In another possible implementation, the chip 2 further includes an active layer 26, and the active layer 26 is disposed on a side that is of the substrate 21 and that is away from the dielectric layer 22. The electronic component 25 is an active device in the active layer 26, for example, as shown in FIG. 7. In another possible implementation, the active layer 26 may alternatively be disposed on the dielectric layer 22. In another possible implementation, the active layer may be disposed on both the dielectric layer 22 and the side that is of the substrate 21 and that is away from the dielectric layer 22.

Certainly, in another possible implementation, the electronic component 25 may alternatively be a passive device, or may be another electronic device, such as a power module.

In some embodiments, a radial size of the first portion decreases in a gradient manner in the first direction F1. The chip structure shown in FIG. 6 is still used or a chip structure shown in FIG. 7 is used as an example. If the first portion is divided into a first segment close to the dielectric layer 22 and a second segment that is away from the dielectric layer 22 and that communicates with the first segment, a minimum radial size of the first segment is greater than a maximum radial size of the second segment. In other words, in a second direction F2 (a direction perpendicular to the first direction F1), a size of the first segment is greater than a size of the second segment.

Based on the foregoing embodiment, the upper inner wall of the first portion may be specifically an inner wall of the first segment, and the protective layer 23 covers the inner wall of the first segment. In addition, a side surface that is of the protective layer 23 and that is close to the conductive pillar 24 is flush with a surface of an inner wall of the second segment, to form a continuous surface with the surface of the inner wall of the second segment. FIG. 8 is an exploded diagram of the chip shown in FIG. 6. In a possible implementation, the second segment has a contact surface that faces the dielectric layer 22 at a junction with the first segment. A thickness of the protective layer 23 at a joint between the protective layer 23 and the contact surface is equal to a size of the contact surface in the second direction. This means that the side surface that is of the protective layer and that is close to the conductive pillar 24 is flush with the surface of the inner wall of the second segment, that is, the side surface that is of the protective layer 23 and that is close to the conductive pillar 24 and the surface of the inner wall of the second segment form a continuous surface. Correspondingly, a radial size of the conductive pillar 24 decreases continuously.

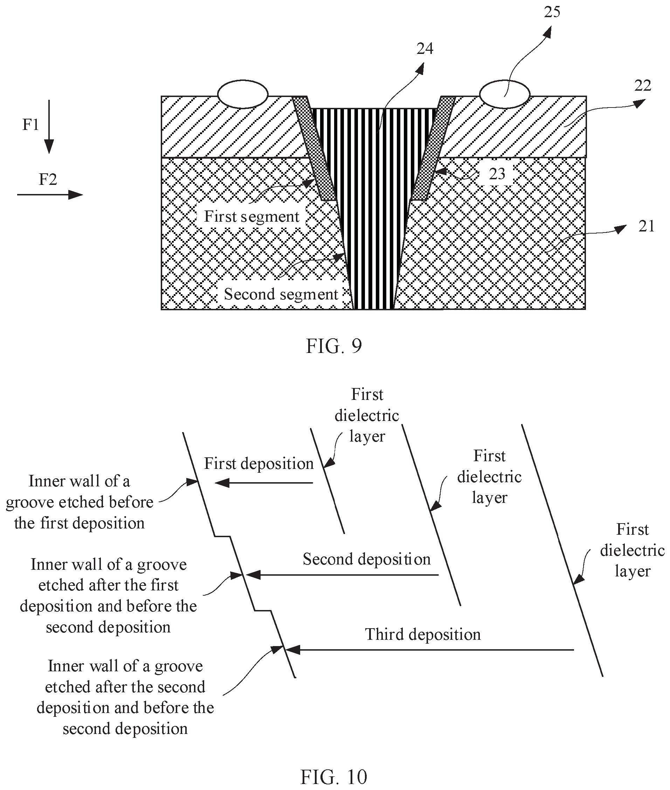

Based on the foregoing embodiment, a surface of an inner wall of the second portion is flush with the side surface that is of the protective layer 23 and that is close to the conductive pillar 24, to form a continuous surface with the side surface that is of the protective layer 23 and that is close to the conductive pillar 24. Alternatively, as shown in FIG. 9, the protective layer 23 further covers the inner wall of the second portion. This means that the side surface that is of the protective layer 23 and that is close to the conductive pillar 24 and the inner wall of the second segment form a continuous surface. In other words, there is no under cut near the junction between the first portion and the second portion. The protective layer 23 and the dielectric layer 22 may be made of a same material, or may be made of different materials. When the protective layer 23 and the dielectric layer 22 are made of a same material, a part that is of the protective layer 23 and that covers the inner wall of the second portion may be connected to the inner wall of the second portion. In other words, at a joint between the protective layer 23 and the dielectric layer 22, there is no observable interface, or there may be an observable interface.

It can be learned from the foregoing embodiment that, there is no under cut near the junction between the first portion and the second portion, and the protective layer 23 is located between the conductive pillar 24 and an inner wall of the via. In other words, before filling of a conductive material used to form the conductive pillar 24, the side surface that is of the protective layer 23 and that is close to the conductive pillar 24 and the surface of the inner wall of the second segment have formed the continuous surface. Therefore, it can be ensured that the conductive material is fully filled, thereby ensuring quality of the conductive pillar 24 and performance of the chip.

In some embodiments, a depth-to-width ratio of the via is greater than or equal to 10. As described in the Background, when the depth-to-width ratio of the via is large, over-etching of the substrate 21 is likely to occur in the second direction, and an under cut is generated near a junction between the substrate 21 and the dielectric layer 22. Therefore, for the chip in embodiments of this application, the depth-to-width ratio of the via in the substrate 21 is greater than or equal to 10. The chip structure solution in embodiments of this application is more applicable to an application scenario in which a chip size is large and a depth-to-width ratio of a via in a substrate is large.

In some embodiments, a radial size of the via at a first position is greater than a radial size of the via at a second position, and the first position is closer to the dielectric layer than the second position. Generally, in a manufacturing process of a chip, if the under cut is generated near the junction between the first portion and the second portion, it means that the TCD of the first portion is greater than the BCD of the second portion. However, in this embodiment of this application, the radial size of the via at the first position is greater than or equal to the radial size of the via at the second position. This means that the TCD of the first portion is less than or equal to the BCD of the second portion, indicating that there is no under cut at the junction between the first portion and the second portion.

In some embodiments, in the first direction, a thickness of the protective layer 23 at a third position is greater than a thickness of the protective layer 23 at a fourth position, and the third position is closer to the dielectric layer 22 than the fourth position. In other words, in the first direction, the thickness of the protective layer 23 tends to decrease. This is because, in a process of etching the via in the substrate 21, according to a depth requirement of the via, the foregoing process of "etching the substrate and depositing the protective layer before the under cut is generated" may be repeated a plurality of times. In other words, as may be shown in FIG. 10, a dielectric is deposited, a plurality of times, on the side wall of the groove that has been etched, so that the thickness of the protective layer 23 increases at a position closer to the dielectric layer 22, and the thickness of the protective layer 23 decreases at a position farther away from the dielectric layer 22.

In some embodiments, the protective layer 23 further covers the inner wall of the second segment. In addition, in the first direction, a thickness of the protective layer 23 at a third position is greater than a thickness of the protective layer 23 at a fourth position, and the third position is closer to the dielectric layer 22 than the fourth position. This is because, in a chip manufacturing process, before filling of the conductive material, an insulation layer and an adhesive layer may be sequentially formed on "the continuous surface formed by the side surface that is of the protective layer and that is close to the conductive pillar and the inner wall of the second segment". When the insulation layer, the adhesive layer, and the protective layer are made of a same material, a structure of a manufactured chip is as follows: The protective layer 23 covers an entire inner wall of the second portion, that is, covers the inner wall of the first segment as well as the inner wall of the second segment, and the thickness of the protective layer 23 tends to decrease in the first direction.

In some embodiments, the continuous surface formed by the protective layer 23 and the surface of the inner wall of the second segment is covered by the insulation layer, and the insulation layer is further covered by the adhesive layer. In this way, the adhesive layer is located between the insulation layer and the conductive pillar, and plays a role of bonding and fastening the conductive pillar.

In the foregoing embodiment, the protective layer includes any one of multi-component materials such as silicon carbon nitride SiCN, silicon oxynitride SiON, silicon oxide OX, silicon nitride SiN, silicon oxycarbonitride SiOCN, silicon carbide SiC, and silicon oxycarbide SiOC. The insulation layer includes silicon oxide or other organic matter, such as various resins. The adhesive layer includes metal or a metal compound, such as TaN or TiN.

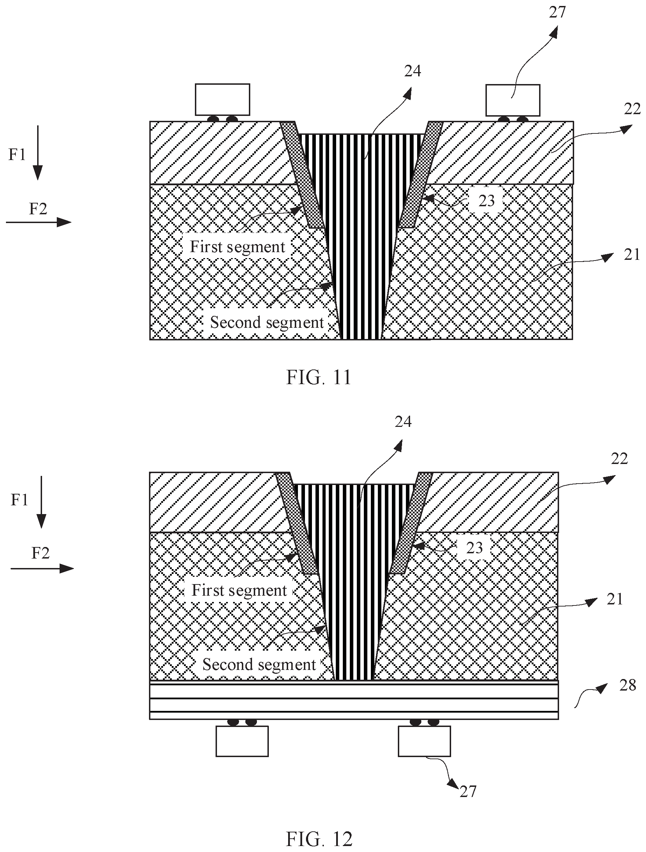

Refer to FIG. 11. With reference to the foregoing embodiments, a semiconductor structure provided in some other embodiments may include a substrate 21, a dielectric layer 22, a protective layer 23, a conductive pillar 24, and a chip 27. For specific implementations of the substrate 21, the dielectric layer 22, the protective layer 23, and the conductive pillar 24, refer to the foregoing embodiments of the chip 2. Details are not described herein again. The chip 27 may be the chip 2 provided in the foregoing embodiments of this application, or may be a chip of another structure. The chip 27 may be disposed on the dielectric layer 22 as shown in FIG. 11, or may be disposed on a side that is of the substrate 21 and that is away from the dielectric layer 22 as shown in FIG. 12, or a plurality of chips may be respectively disposed on the dielectric layer 22 and the side that is of the substrate 21 and that is away from the dielectric layer 22. Generally, in an implementation shown in FIG. 11, a wiring layer 28 may be disposed on the side that is of the substrate 21 and that is away from the dielectric layer 22, the chip 27 is disposed on the wiring layer 28, and the conductive pillar 24 may be electrically connected to a circuit in the wiring layer 28, so that the conductive pillar 24 is electrically connected to the chip 27 through the circuit in the wiring layer 28. In the implementations shown in FIG. 11 and FIG. 12, the semiconductor structure is specifically a chip package structure. The substrate 21, the dielectric layer 22, the protective layer 23, the conductive pillar 24, and the wiring layer 28 form a base board used to package the chip 27.

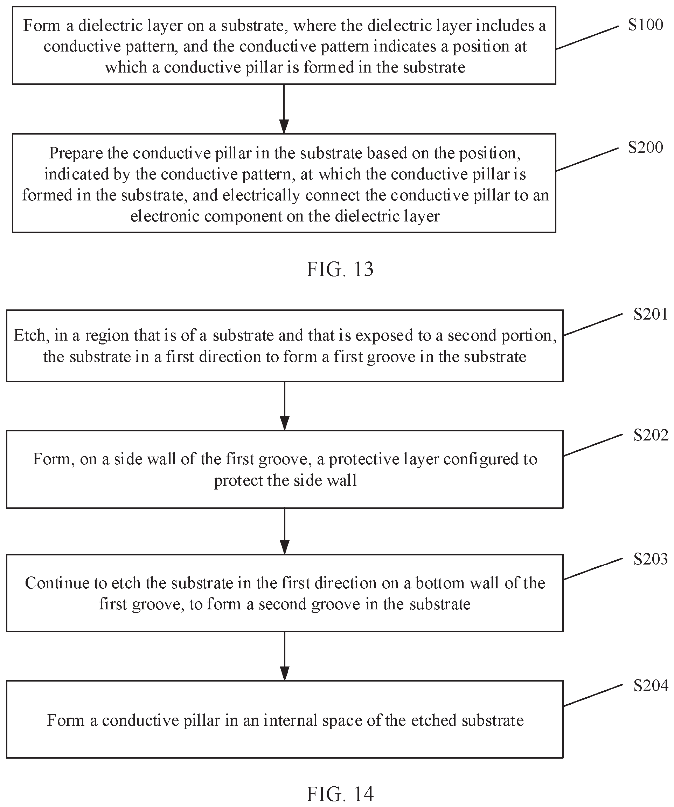

An embodiment of this application further provides a manufacturing method for a semiconductor structure. As shown in FIG. 13, the manufacturing method may include the following steps.

S100: Form a dielectric layer on a substrate, where the dielectric layer includes a conductive pattern, and the conductive pattern indicates a position at which a conductive pillar is formed in the substrate.

In some embodiments, the dielectric layer is first formed on the substrate, and then an exposed conductive pattern is transferred to the dielectric layer through a dielectric etching cavity, to form a mask for silicon.

In some embodiments, the dielectric layer further includes an active region, and an electronic device is formed in the active region. In S100, the dielectric layer is first formed on the substrate, and then an active device is prepared in the dielectric layer, to form the active region. Then, the exposed conductive pattern is transferred to the active layer through the dielectric etching cavity, to form the mask for silicon.

S200: Prepare the conductive pillar in the substrate based on the position, indicated by the conductive pattern, at which the conductive pillar is formed in the substrate, and electrically connect the conductive pillar to an electronic component on the dielectric layer.

The conductive pillar is formed in a via that passes through the dielectric layer and the substrate in a first direction. The via includes a first portion formed within the substrate. A part of an inner wall that is of the first portion and that is close to the dielectric layer is covered by a protective layer. The first direction is a direction from the dielectric layer to the substrate.

In some embodiments, the via further includes a second portion formed within the dielectric layer, and the conductive pattern includes the second portion.

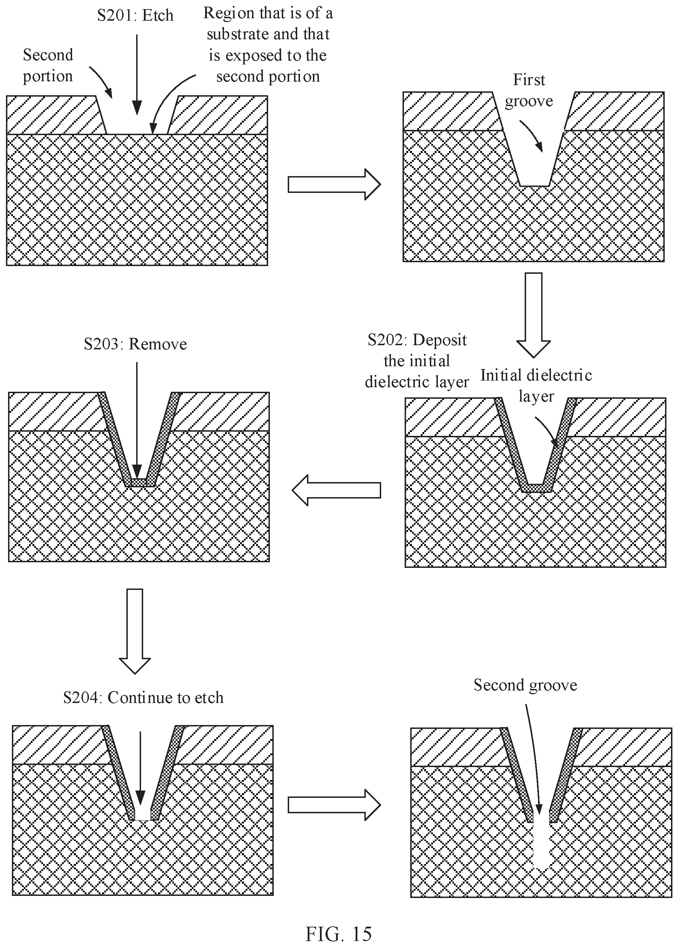

As shown in FIG. 14 and FIG. 15, S200 of preparing the conductive pillar in the substrate based on the position, indicated by the conductive pattern, at which the conductive pillar is formed in the substrate may specifically include:
S201: Etch, in a region that is of the substrate and that is exposed to the second portion, the substrate in the first direction to form a first groove in the substrate. The first groove subsequently forms the first segment of the first portion mentioned in the foregoing chip structure embodiment.

In some embodiments, a surface of a side wall of the first groove is flush with a surface of an inner wall of the second portion.

In some embodiments, at a junction between the first groove and the second portion, a size of the first groove in a second direction is equal to a size of the second portion in the second direction.

S202: Form, on the side wall of the first groove, the protective layer used to protect the side wall.

Specifically, an initial dielectric layer is first formed on an inner wall of the first groove, and then a part that is of the initial dielectric layer and that is located on a bottom wall of the first groove is removed. The initial dielectric layer reserved on the side wall of the first groove is the foregoing protective layer.

In some possible implementations, forming the initial dielectric layer on the inner wall of the first groove specifically includes: forming the initial dielectric layer on an inner wall of the second portion and the inner wall of the first groove.

S203: Continue to etch the substrate in the first direction on the bottom wall of the first groove, to form a second groove in the substrate. The first groove subsequently forms the second segment of the first portion mentioned in the foregoing chip structure embodiment.

In some embodiments, a side surface that is of the protective layer and that is away from an inner wall of the substrate is flush with a surface of an inner wall of the second groove.

In some embodiments, a minimum radial size of the first groove in the second direction is greater than a maximum radial size of the second groove in the second direction.

It should be noted that S202 and S203 are a cycle of "etching the substrate and depositing the protective layer before an under cut is generated" mentioned in the foregoing chip structure embodiment. According to a depth requirement of the via, the process may be repeated a plurality of times until the via reaches an expected depth.

S204: Form the conductive pillar in an internal space of the etched substrate. The internal space of the substrate herein is the space formed by the first segment and the second segment, or a space formed by communicating the first groove with the second groove.

Specifically, an insulation layer is first formed on the protective layer and the surface of the inner wall of the second groove. Next, an adhesive layer is formed on the insulation layer. Then a conductive material is filled in a space obtained after the insulation layer and the adhesive layer are formed. The conductive pillar is formed after processing such as annealing is performed. Finally, polishing processing is performed on a side that is of the substrate and that is away from the dielectric layer, so that a size of the conductive pillar in the first direction meets a process requirement, and an end that is of the conductive pillar and that is away from the dielectric layer is exposed outside the substrate.

The semiconductor structure shown in FIG. 6 may be obtained through S100 and S200.

In some embodiments, the manufacturing method for the semiconductor structure further includes: forming an active layer on the side that is of the substrate and that is away from the dielectric layer, and electrically connecting the electronic component in the active layer to the conductive pillar.

The semiconductor structure shown in FIG. 7 may be obtained by using the foregoing manufacturing method.

In some embodiments, the manufacturing method for the semiconductor structure further includes: installing a chip on the dielectric layer and/or on the side that is of the substrate and that is away from the dielectric layer.

In a possible process implementation, a wiring layer is first formed on the side that is of the substrate and that is away from the dielectric layer, and a circuit in the wiring layer is electrically connected to the conductive pillar. Then, the chip is installed on the wiring layer, and the chip is electrically connected to a circuit in the wiring layer. In this way, the chip is electrically connected to the conductive pillar through the wiring layer, to obtain the chip package structure shown in FIG. 12.

It can be learned from the foregoing manufacturing method that, in a process of etching the via in the substrate, before the under cut is generated, the protective layer is formed on an upper inner wall of the first portion (in this case, an inner wall of a groove that has been etched in the substrate forms an upper inner wall of a first portion in a subsequently manufactured finished chip), to protect the upper inner wall of the first portion through the protective layer. Then, the substrate continues to be etched to deepen a depth of the groove. If the process is briefly described as "etching the substrate and depositing the protective layer before the under cut is generated", a depth of the via required by the process can be achieved by repeating the process a plurality of times. In addition, the protective layer protects the upper inner wall of the first portion. In this way, during etching of the via in the substrate, no over-etching is caused to the substrate in a width direction of the via as an etching depth increases. Therefore, the TCD of the first portion is not greater than the BCD of the second portion, that is, generation of the under cut is avoided near the junction between the first portion and the second portion.

In the descriptions of this specification, the described specific features, structures, materials, or characteristics may be combined in a proper manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A semiconductor structure, comprising:
a substrate; and
a dielectric layer, stacked on the substrate, wherein there is a via that passes through the dielectric layer and the substrate in a first direction, the via comprises a first portion formed within the substrate, and the first direction is a direction from the dielectric layer to the substrate;
a protective layer, covering a part of an inner wall that is of the first portion and that is close to the dielectric layer;
a conductive pillar, disposed in the via; and
an electronic component, electrically connected to the conductive pillar.

2. The semiconductor structure according to claim 1, wherein the first portion comprises a first segment close to the dielectric layer and a second segment that is away from the dielectric layer and that is continuous with the first segment, and a minimum radial size of the first segment is greater than a maximum radial size of the second segment; and
the protective layer covers an inner wall of the first segment, and a side surface that is of the protective layer and that is close to the conductive pillar is flush with a surface of an inner wall of the second segment.

3. The semiconductor structure according to claim 2, wherein the second segment has a contact surface that faces the dielectric layer at a junction with the first segment; and
a side that is of the protective layer and that is close to the second segment is connected to the contact surface; a thickness of the protective layer at a joint between the protective layer and the contact surface is equal to a size of the contact surface in a second direction; and the second direction is a direction perpendicular to the first direction.

4. The semiconductor structure according to any one of claims 1 to 3, wherein the dielectric layer further comprises an active region, and the active region comprises the electronic component.

5. The semiconductor structure according to any one of claims 1 to 4, wherein the semiconductor structure further comprises:
an active layer, disposed on the dielectric layer and/or a side that is of the substrate and that is away from the dielectric layer, wherein the active layer comprises the electronic component.

6. The semiconductor structure according to any one of claims 1 to 5, wherein the semiconductor structure further comprises:
a chip, disposed on the dielectric layer and/or the side that is of the substrate and that is away from the dielectric layer, wherein
the chip comprises the electronic component.

7. The semiconductor structure according to any one of claims 1 to 6, wherein a depth-to-width ratio of the via is greater than or equal to 10:1.

8. The semiconductor structure according to any one of claims 1 to 7, wherein a radial size of the via at a first position is greater than a radial size of the via at a second position, and the first position is closer to the dielectric layer than the second position.

9. The semiconductor structure according to any one of claims 1 to 8, wherein a radial size of the conductive pillar decreases continuously in the first direction.

10. The semiconductor structure according to any one of claims 1 to 8, wherein a radial size of the first portion decreases in a gradient manner in the first direction.

11. The semiconductor structure according to any one of claims 1 to 10, wherein in the first direction, a thickness of the protective layer at a third position is greater than a thickness of the protective layer at a fourth position, and the third position is closer to the dielectric layer than the fourth position.

12. The semiconductor structure according to any one of claims 1 to 11, wherein the via further comprises a second portion formed within the dielectric layer, and a surface of an inner wall of the second portion is flush with the side surface that is of the protective layer and that is close to the conductive pillar.

13. The semiconductor structure according to any one of claims 1 to 8, wherein the via further comprises a second portion formed within the dielectric layer, and the protective layer further covers an inner wall of the second portion.

14. The semiconductor structure according to claim 2 or 3, further comprising:
an insulation layer, covering a continuous surface formed by the protective layer and the surface of the inner wall of the second segment.

15. The semiconductor structure according to claim 14, further comprising:
an adhesive layer, covering the insulation layer, and located between the conductive pillar and the insulation layer.

16. The semiconductor structure according to any one of claims 1 to 15, wherein the protective layer comprises silicon carbon nitride SiCN, silicon oxynitride SiON, silicon oxide OX, silicon nitride SiN, silicon oxycarbonitride SiOCN, silicon carbide SiC, or silicon oxycarbide SiOC.

17. The semiconductor structure according to any one of claim 14 or 15, wherein the insulation layer comprises silicon dioxide or another organic matter.

18. A manufacturing method for a semiconductor structure, comprising:
forming a dielectric layer on a substrate, wherein the dielectric layer comprises a conductive pattern, and the conductive pattern indicates a position at which a conductive pillar is formed in the substrate; and
preparing the conductive pillar in the substrate based on the position, indicated by the conductive pattern, at which the conductive pillar is formed in the substrate, and electrically connecting the conductive pillar to an electronic component on the dielectric layer, wherein
the conductive pillar is formed in a via that passes through the dielectric layer and the substrate in a first direction; the via comprises a first portion formed within the substrate; a part of an inner wall that is of the first portion and that is close to the dielectric layer is covered by a protective layer; and the first direction is a direction from the dielectric layer to the substrate.

19. The manufacturing method for a semiconductor structure according to claim 18, wherein the via further comprises a second portion formed within the dielectric layer, and the conductive pattern comprises the second portion; and
preparing the conductive pillar in the substrate based on the position, indicated by the conductive pattern, at which the conductive pillar is formed in the substrate comprises:
etching, in a region that is of the substrate and that is exposed to the second portion, the substrate in the first direction to form a first groove in the substrate, wherein the first groove forms a first segment of the first portion;
forming, on a side wall of the first groove, the protective layer used to protect the side wall;
continuing to etch the substrate in the first direction on a bottom wall of the first groove, to form a second groove in the substrate, wherein the second groove forms a second segment of the first portion; and
forming the conductive pillar in a space formed by the first segment and the second segment.

20. The manufacturing method for a semiconductor structure according to claim 19, wherein forming, on the side wall of the first groove, the protective layer used to protect the side wall comprises:
forming an initial dielectric layer on an inner wall of the first groove; and
removing a part that is of the initial dielectric layer and that is located on the bottom wall of the first groove.

21. The manufacturing method for a semiconductor structure according to claim 19, wherein a surface of the side wall of the first groove is flush with a surface of an inner wall of the second portion.

22. The manufacturing method for a semiconductor structure according to claim 19, wherein at a junction between the first groove and the second portion, a size of the first groove in a second direction is equal to a size of the second portion in the second direction, and the second direction is perpendicular to the first direction.

23. The manufacturing method for a semiconductor structure according to claim 19, wherein a side surface that is of the protective layer and that is close to the conductive pillar is flush with a surface of an inner wall of the second groove.

24. The manufacturing method for a semiconductor structure according to claim 19, wherein a minimum radial size of the first groove in a second direction is greater than a maximum radial size of the second groove in the second direction, and the second direction is perpendicular to the first direction.

25. The manufacturing method for a semiconductor structure according to claim 19, wherein forming the conductive pillar in the space formed by the first segment and the second segment comprises:
forming an insulation layer on the protective layer and a surface of an inner wall of the second groove;
forming an adhesive layer on the insulation layer; and
forming the conductive pillar in the space obtained after the insulation layer and the adhesive layer are formed.

26. The manufacturing method for a semiconductor structure according to claim 20, wherein forming the initial dielectric layer on the inner wall of the first groove comprises:
forming the initial dielectric layer on an inner wall of the second portion and the inner wall of the first groove.

27. An electronic device, comprising:
a mainboard; and
the semiconductor structure according to any one of claims 1 to 17 that is electrically connected to the mainboard.
